# EUROPEAN PATENT APPLICATION

(11) **EP 4 560 694 A1**
(43) Date of publication of application: **28.05.2025**
(21) Application number: 24212353.7
(22) Date of filing: 12.11.2024
(51) Int. Cl.: H01L 23/16, H01L 21/56, H05K 1/14, H01L 23/057

(54) **RIGID-FLEXIBLE PCB, POWER MODULE INCLUDING THE PCB, AND MANUFACTURING METHOD OF THE POWER MODULE**

(30) Priority: 27.11.2023 IT 202300025182
(71) Applicant: STMicroelectronics International N.V., 1228 Plan-les-Ouates, Geneva (CH)
(72) Inventor: ZIZZA, Luciano, 95123 CATANIA (IT); SALAMONE, Francesco, 95024 ACIREALE (CT) (IT)
(74) Representative: Studio Torta S.p.A.

(57) **Abstract**

In a power module, a rigid-flexible PCB (20) exits from a resin molding case, and includes: a first PCB region having a stacked structure of piled up layers; a second PCB region having said stacked structure, further locally delimited at a first side by a top stiffening element (56) and at a second opposite side by a bottom stiffening element (62); and a third PCB region having said stacked structure without the top and bottom stiffening elements. The top and bottom stiffening elements extend at a surface (14c) of the molding case, where the PCB exits from the molding case, and are configured to locally increase the rigidity of the PCB with respect to regions of the PCB 20 where said top and bottom stiffening elements are absent.

## Description

### TECHNICAL FIELD

The present invention relates to a rigid-flexible PCB, to a power module and to a manufacturing method of the power module.

### BACKGROUND ART

In the known art, Transfer Mold Modules (TMMs) power modules (PMs) for traction inverter have a rigid structure adapted to mass production, since they use an overmolded case typically used in the mass production of discrete electronic components. Players in the automotive field are asking for product families configured to cover the widest possible range of powers and applications. However, slightly different applications often require expensive modifications in terms of Product Outline Assembled drawing (POA) for TMM PMs.

In the same time PM manufacturer would like to offer flexible but reliable open market solutions in terms of POA.

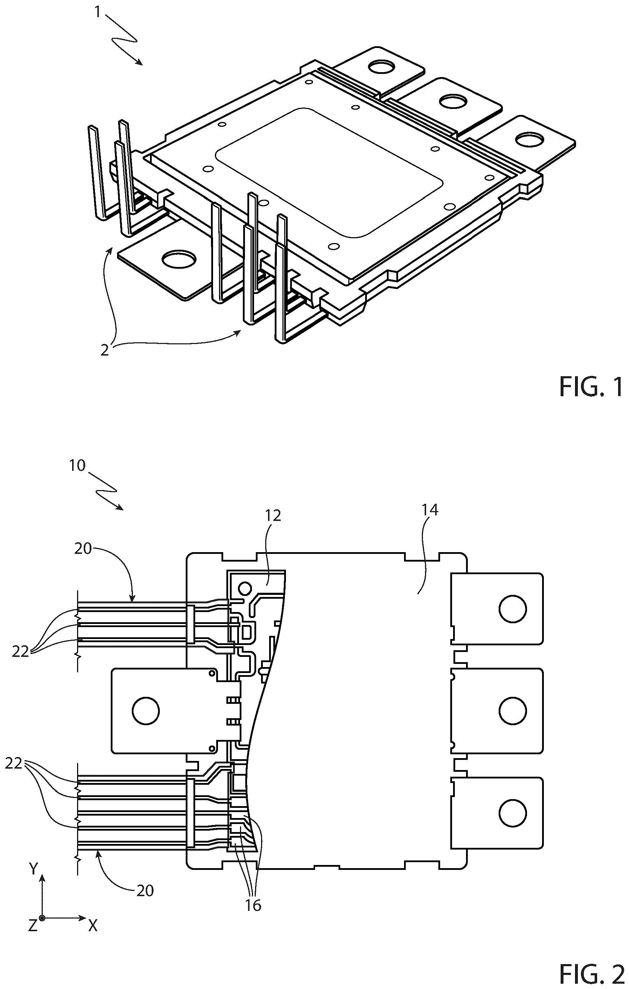

In the known art (Figure 1) it is common to build a TMM package using a rigid leadframe 1 that is provided with rigid connections (bus bars for power connection) and control pins (needle-like) 2 for control input connections, that are bended after the molding step. The rigid connections 2 exit from the package molding (resin plastic case) for connections with PCBs. As anticipated above, the packages thus manufactured are good for mass production. However, many customers require assemblies that cover the widest possible range of applications. Different applications often require expensive modifications to the production line.

The leadframe that lies between the two parts of the mold does not allow sustainable flexibility of the position of the control pins without modifying the leadframe itself and the molding tool.

There is therefore the need to provide a solution that allows greater flexibility in terms of possible applications, without impacting on the manufacturing / production line in terms of expensive modification of the manufacturing / production line.

Patent application US2018/130757A1 elates to packaging of integrated circuits ("ICs"). More particularly, the following description relates to foldable arrangements for ICs.

Patent application US2023/114396A1 relates to a power module comprising a rigid insulated substrate mounted on a baseplate.

Patent application US2014/034366A1 relates to a rigid-flexible substrate and a method for manufacturing the same.

However, the above-mentioned issues are not solved.

### SUMMARY OF THE INVENTION

According to the present invention, a rigid-flexible PCB, a power module and a manufacturing method of the power module are provided, as defined in the attached claims.

### BRIEF DESCRIPTION OF THE DRAWINGS

For a better understanding of the present invention, preferred embodiments thereof are now described, purely by way of non-limiting example, with reference to the attached drawings, wherein:
- Figure 1 illustrates a TMM PM according to the known art;
- Figure 2 illustrates a power module according to the invention;
- figure 3 illustrates an enlarges portion of the power module of Figure 2;
- Figure 4 illustrates a section view of the portion of Figure 3;
- Figure 5 illustrates a more detailed embodiment of the section of Figure 4, according to one aspect of the invention;
- Figure 6 illustrates a more detailed embodiment of the section of Figure 4, according to another aspect of the invention; and
- Figures 7A and 7B illustrate part of a manufacturing process to manufacture part of the power module of Figure 2.

### DETAILED DESCRIPTION OF EMBODIMENTS OF THE INVENTION

Figure 2 shows a power module 10 in a triaxial system of orthogonal axis X, Y, Z. The power module 10 is represented in an intermediate manufacturing step and in a top-plan view on plane XY.

The power module 10 comprises a rigid or solid portion (or rigid / solid body) 12, including one or more layers of conductive material, for example Copper (Cu). The rigid portion 12 is at least partially covered by a molding case 14 of electrically-insulating material (for example made from epoxy resin, epoxy-based molding compounds, or other plastic material). The molding case 14 is for example formed by Resin Transfer Molding (RTM), in a manner which is per se known in the art. The molding case 14 is illustrated opened at selective portions for a better understanding of the present invention and to illustrate more clearly the top conductive layer of the rigid portion 12 and other elements relevant for the invention disclosed.

In one exemplary embodiment, the molding case 14 has a first surface 14a, a second surface 14b and at least one third surface 14c physically connecting together the first surface 14a and the second surface 14b. A fourth surface 14d is also present, physically connecting together the first surface 14a and the second surface 14b at an opposite side with respect to the third surface 14c. The first surface 14a and the second surface 14b are, in particular, parallel to plane XY, while the third surface 14a is, in particular, parallel to plane YZ. Optionally, also the fourth surface 14d is parallel to plane YZ. Even though not shown in the drawings, it is apparent that the molding case 14 has a further fifth surface connecting the first surface 14a to the second surface 14b along, or substantially along, plane XZ, and a sixth surface, opposite to the fifth surface, connecting the first surface 14a to the second surface 14b along, or substantially along, plane XZ. In general, the molding case 14 has, in one embodiment, a polyhedric shape with a plurality of polygonal faces or surfaces optionally, one or more of such faces or surfaces is/are flat or substantially flat, depending on the production process.

In one embodiment, the molding case 14 is a hexahedron or sexahedron, for example having a cubic shape or a box-like shape.

The rigid portion 12 is shaped in such a way to define a plurality of conductive paths 16, for signal transfer.

According to an aspect of the invention, the power module 10 further comprises one or more PCBs 20 (FPC, FPC with stiffener, Rigid-Flex PCB, etc.), each PCB 20 including a flexible insulating support over which (or within which) one or more conductive tracks or traces extend. The PCBs 20 are therefore also referred to as flexible PCBs 20. For example, each PCB 20 is configured to be curved or bended up to at least 90 degrees or at least 180 degrees or to 360 degrees with respect to a rest condition of the PCB, without undergo damages or without breaking or without losing its functionalities.

The flexible PCBs 20 are in the form of elongated stripes (a plurality of flexible stripes 20 is shown in figure 2, without losing generality). The conductive tracks of each flexible stripe 20 are electrically coupled to the rigid portion 12, in particular to at least one respective conductive path 16.

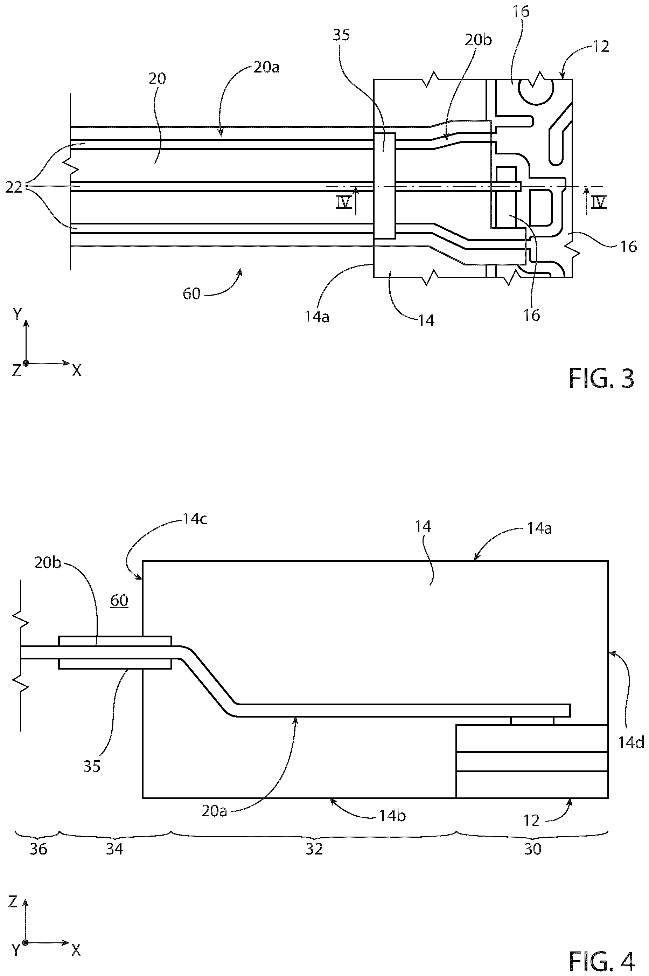

Figure 3 illustrates (in top-plan view, on XY plane) an enlarged view of Figure 2, at a point where one flexible stripe 20 is coupled to the rigid portion 12. As shown, the flexible stripe 20 includes a plurality of conductive traces 22. Typically, the conductive traces extend parallel to one another; in general, the extend on an insulating portion of the flexible stripe 20 and form respective conductive paths electrically isolated from one another. Each conductive trace 22 is for example made of copper.

Figure 4 shows schematically a section (on plane XZ) of the view of Figure 3, considered along the section line IV-IV of Figure 3.

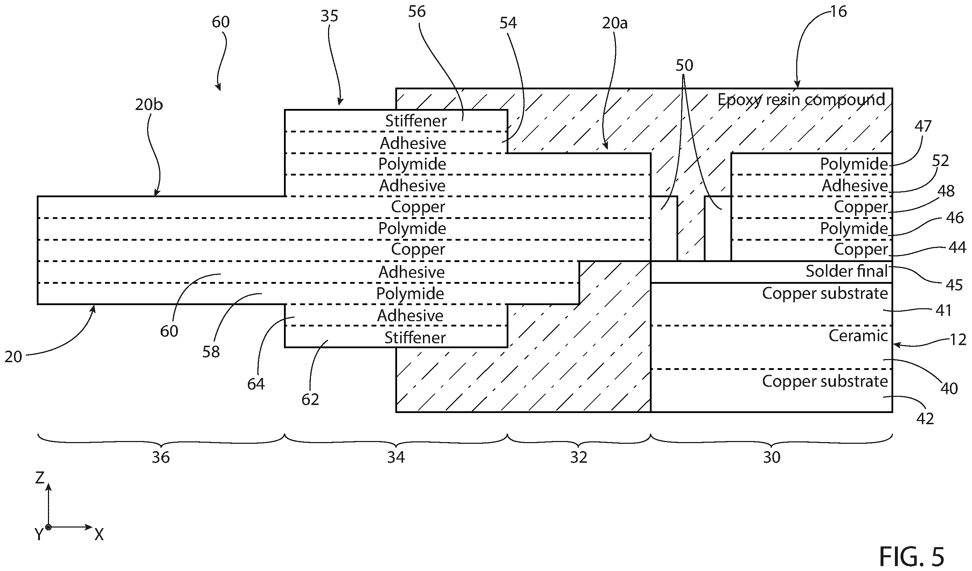

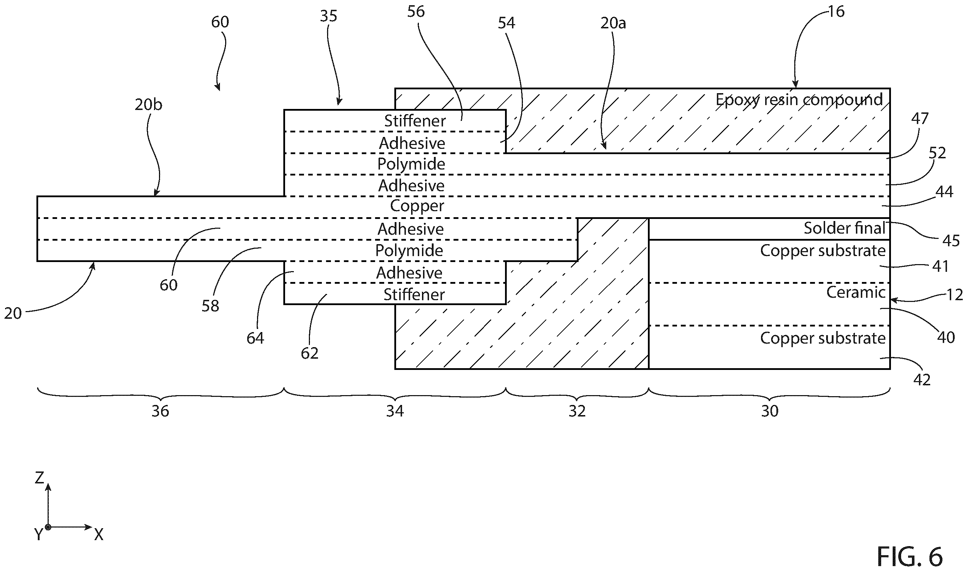

Figures 5 and 6 illustrates detailed embodiments of material stacks of the section of Figure 4.

With joint reference to figures 3-6, the power module 10 comprises four main portions or regions 30-36:
A first region 30 includes the rigid portion 12, including the electrical connections between the rigid portion 12 (in particular the paths 16) and the flexible stripe 20.

A second region 32 includes a part 20a of the flexible stripe 20 that depart from the rigid portion 12 (to which is electrically and physically coupled), or otherwise extends from the rigid portion 12 towards an external environment 60, which is external to the power module 10.

The first region 30 and the second region 32 are covered by a solidified resin, that form the molding case 14. In particular, the part 20a of the flexible stripe 20 that is buried within the molding case 14 is rigidly retained with the molding case 14 and, after manufacturing of the molding case 14, the part 20a of the flexible stripe 20 is fixed or blocked in its position and is prevented from moving.

A third region 34 forms a transition for the flexible stripe 20 between the molding case 14 and the external environment 60. A transition portion 35 is therefore provided at an "exit point" (in particular, the third surface 14c) of the molding case, where the flexible stripe 20 exits from the molding case 14. The transition portion 35 is more rigid than the second region 32 (and more rigid than the fourth region 36 later described). In one embodiment, the transition portion 35 extend in part within the molding case 14 and in part outside the molding case 14; in another embodiment, the transition element is completely contained within the molding case 14; in another embodiment, the transition portion 35 has an outer surface, exposed toward the external environment 60, which is coplanar with the third surface 14c of the molding case 14. The transition portion 35 includes for example one or more films or layers of a non-conductive material (e.g. polyimide) configured to act as local stiffeners for the flexible stripe 20. The stiffening films may, for example, be of Kapton^{®}. Other materials that can be used for the stiffening films include (but are not limited to): FR4, IMS, polyimide, other plastic and/or compound material, aluminum, stainless steel, copper and their alloy.

A fourth region 36 includes a part 20b of the flexible stripe 20 that departs from the transition portion 35; said in other words, the part 20b of the flexible stripe 20 extends from the transition portion 35 toward the external environment 60 and terminates in the external environment 60. Out of the molding material and out of the transition portion 35, the flexible stripe 20 is free to move and can be bended according to the circumstances to be communicatively coupled to an external PCB or other device, by joining for instance a JEDEC compliant connector, thus forming an electrical connection of the power module 10, for transfer of electric signals (including for example one or more among electric power supply, informative data, signals, etc.).

The second region 34 and the fourth region 36 are formed, at least in a respective portion, by a same stack of piled-up layers and/or films. The third portion 34 includes the same stack, but differs from the second and fourth portions by the further presence of the stiffening films that protect and stiffen, at the top and at the bottom, the stack of piled-up layers/films.

Where the stiffening films are present, the flexible stripe 20 has a higher local rigidity in the range 20-40 kg/cm²; where the stiffening films are absent, the flexible stripe 20 has a lower local rigidity in the range 30-50 kg/cm² .

In particular, the lower local rigidity is achieved at the second region 32 (however, due to the presence of the molding case 14, at the second region the flexible stripe is blocked and is not free to move or bend). The lower local rigidity is also achieved at the fourth portion 36, after the transition portion 35. The higher local rigidity is achieved at the transition portion 35 (third region 34).

Figure 5 is a more detailed representation of the section of Figure 4, where the sub-layers forming the power module 10 (limited to the regions 32-36 previously described) are shown.

With reference to the first region 30, the rigid portion 12 of the power module 10 includes a ceramic substrate 40 extending between top and bottom conductive substrates 41, 42 (e.g., of metal material such as Cu). The substrates 41 and 42 are coupled to the intermediate substrate 40 for example my means of solder reflow, or ultrasonic welding, or laser welding, or pressureless sintering, or conductive glue.

The flexible stripe 20 is physically and electrically coupled to the rigid portion 12 (e.g. by soldering) at a coupling region 45. The flexible stripe 20 extends on top of the conductive substrate 41 and is therefore soldered to the top conductive substrate 41 at a soldering region 45. The flexible stripe 20 (in particular, the first part 20a) includes a first conductive layer 44 (e.g., of metal material such as Cu), a first polyimide layer 46 that extends on the first conductive layer 44, and a second conductive layer 48 (e.g., of metal material such as Cu) that extends on the first polyimide layer 46 and is electrically connected to the first conductive layer 44 by means of one or more conductive vias 50 (e.g., of metal material such as Cu). In this way, the first polyimide layer 46 extends (or is sandwiched) between the first and the second conductive layer 44, 48. A second polyimide layer 47 of the flexible stripe 20 extends on the second conductive layer 48 and is physically coupled to the second conductive layer 48 by means of an adhesive film 52.

The transition portion 35 is formed as a part of the flexible stripe 20 by coupling, on the second polyimide layer 47 by means of glue or by means of an adhesive film 54, a top stiffening film or layer 56 (this stiffening film may be of Kapton material or another proper material, as listed before). The transition portion 35 further includes a third polyimide layer 58 extending on the exposed surface of the first conductive layer 44 (i.e., the surface of layer 44 opposite to the one on which the first polyimide layer 46 extends). The third polyimide layer 58 is coupled to the first conductive layer 44 by means of an adhesive film 60. On the third polyimide layer 58, a bottom stiffening film or layer 62 extends (this stiffening film may be of Kapton material or another proper material, as listed before, analogously the top stiffening film 56). The bottom stiffening film 62 is coupled to the third polyimide layer 58 by means of glue or by means of an adhesive film 64.

The flexible stripe 20 has an elongated shape having a main extension, when stretched, along the X axis. The flexible stripe 20 has for example an extension, along the X axis, between few millimeters (e.g., from 2 mm) and few centimeters (e.g., up to 6-10 cm), depending on the applications and circumstances. The length of the stiffening films 56, 62, along the X axis, is for example equal to or higher than 2 mm. The length along the X axis of the portion 32 (i.e., the part 20a of the stripe 20 embedded in the molding case 14 until the coupling region 45 with the rigid portion 12) is for example in the range of 1-10 mm.

Figure 5 shows that the transition portion 35 extends in part within the molding material and in part outside the molding material; however, the present invention is not limited to this specific embodiment, and the description of Figure 5 applies as well to the other disclosed embodiments where the transition portion 35 is completely contained within the molding material or has an outer surface coplanar with a corresponding outer surface of the molding material/case 14.

With further reference to Figure 5, the second part 20b of the flexible stripe 20 has the same section, in terms of materials stack, of the first part 20a and therefore it is not further described.

Figure 6 illustrates a further embodiment of the flexible stripe 20, which is alternative to that of Figure 5. Common elements / features of the embodiments of Figure 5 and Figure 6 are identified with the same reference numerals and not further described. In the embodiment of Figure 6, the flexible stripe 20 includes only one conductive layer (e.g., the first conductive layer 44), and it does not include the polyimide layer 46, the conductive vias 50 and the second conductive layer 48. Therefore, polyimide layers 47, 58 (corresponding to the second and third polyimide layers 47, 58 of Figures 5) extend at opposite sides of the conductive layer 44, coupled to the conductive layer 44 by means of the adhesive films 52, 60.

The embodiment of Figure 5 is capable of handling higher currents than the embodiment of Figure 6, and therefore can be selected when the maximum current level handled by the flexible trace 20 must be improved (depending on the application).

Exemplary thicknesses (along Z direction) of the layers/films of Figures 5 and 6 are indicated below as possible ranges and preferred values (ends of ranges are included as possible thickness values).

Rigid portion 12 (e.g., between about 600 and 1400 µm):
- Top copper substrate 41: 300-800 pm, preferably 500pm,
- Bottom copper substrate 42: 300-800 pm, preferably 500pm,
- Ceramic substrate 40: 0.2-0.65 mm.

Soldering 45: 40-70 pm, preferably 60pm.
PCB 20 (e.g., total thickness between 100 µm and 400 µm where the stiffening film are not present; between 200 µm and 1000 µm where the stiffening films are present):
   - First conductive layer 44: 15-35 pm, preferably 18um,
   - First polyimide layer 46: 20-75 pm, preferably 25pm,
   - Second conductive layer 48: 15-35 pm, preferably 18um,
   - First adhesive film 52: 20-75 pm, preferably 25pm,
   - Second adhesive film 60: 20-75 pm, preferably 25pm,
   - Second polyimide layer 47: 10-50 pm, preferably 25pm,
   - Third polyimide layer 58: 10-50 pm, preferably 25pm,
   - Top stiffening film 56: 50-300 µm,
   - Bottom stiffening film 62: 50-300 µm.

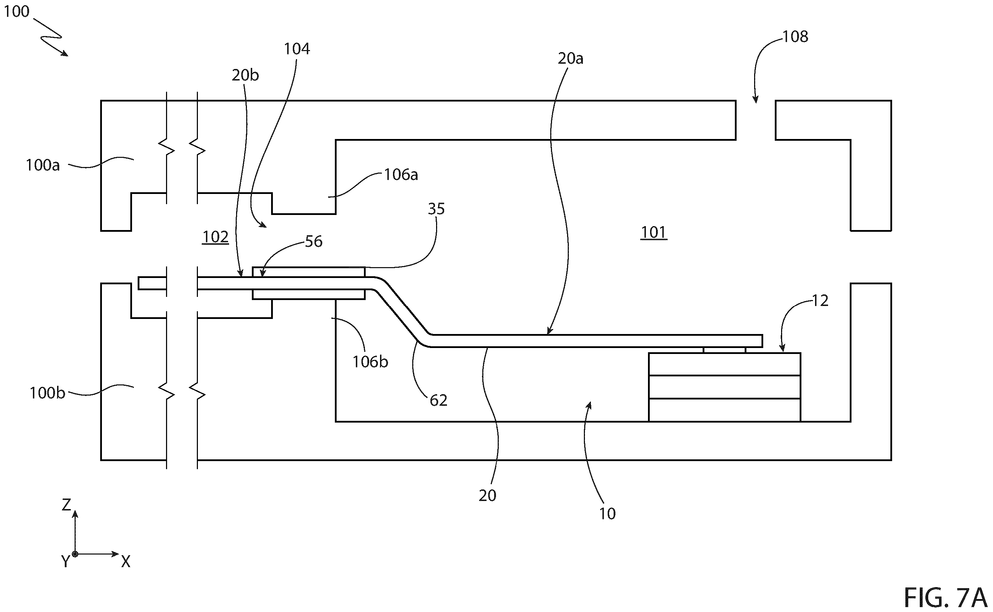

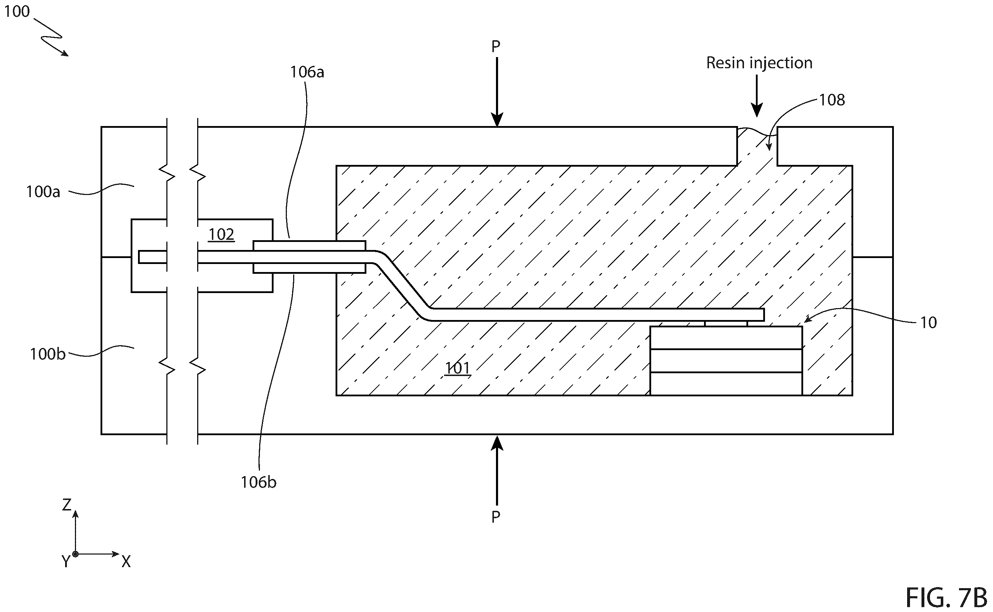

Part of the manufacturing process of the power module 10 is illustrated in figures 7A and 7B, limited to steps relevant to the present invention (in particular, the resin injection and the advantages associated to the presence of the top and bottom stiffening films 56, 62).

After having coupled (by gluing, soldering, etc.) the flexible stripes 20 to the rigid portion 12, and before having formed the molding case 14, the power module 10 is inserted on a supporting portion of a mold chase 100 (Figure 7A). The mold chase 100 is for example of stainless steel.

The mold chase 100 includes a first portion 100a and a second portion 100b, configured to couple together in such a way to define a first inner chamber 101 and a second inner chamber 102. The first inner chamber 101 is shaped to house the rigid portion 12 and the first part 20a of the flexible portions 20. The second inner chamber 102 is shaped to house the second part 20b of the flexible stripes 20. The mold 100 includes a transition region 104 between the inner chambers 101, 102, including top and bottom restriction elements 106a, 106b. The mold chase 100 is configured such that, when the power module 10 is arranged in the mold chase 100, the transition portion 35 extends at least in part at the transition region 104, between the inner chambers 101, 102.

An opening 108 in the mold chase 100, fluidically coupled to the first inner chamber 101 but not to the second inner chamber 102, is configured to allow resin injection within the first inner chamber 101.

The top and bottom restriction elements 106a, 106b are shaped such that, when the portions 100a, 100b of the mold chase 100 are coupled together before resin injection, the top and bottom restriction elements 106a, 106b are adjacent to the top stiffening film 56 and to the bottom stiffening film 62, respectively. When the mold is closed, the top and bottom restriction elements 106a, 106b apply a certain force on the top and bottom stiffening films 56, 62, such that, when the resin is injected within the first inner chamber 101, the same resin does not flow out of the inner chamber 101 toward the second inner chamber 102. The same function of dumbar in mold chase leadframe cavity. The force (pressure) P is exerted at opposite sides of the mold (along the Z direction), and is for example in the range of the pressure injection resin, e.g. 4-7 MPa.

The presence of the top and bottom stiffening films 56, 62 aids avoiding the resin to flow into the second inner chamber and at the same time protects the flexible stripe 20 from being damaged during the pressing of the mold chase 100.

Then, a step of curing the resin is carried out, in a per se known way (depends upon the type of resin used), to solidify the resin.

Then, the mold chase 100 is removed.

After manufacturing (i.e., in the final power module 10) the presence of the transition portion 35 is useful for indention via fiducials.

From what has been previously discussed, the advantages which the present invention affords are evident.

Further to the advantages already noted, the proposed solution makes SIP production very flexible in product families or open market versions not necessarily bound to the customer's request, with cost reduction. Furthermore, the possibility of having overlapped layers can allow the reduction of the L-stray inductance inside the module.

The rigid section (rigid dambar) with the rigid element exiting the plastic case allows overcoming the difficulties of the applicability of the flex PCB alone in terms of resin injection temperatures thanks to the choice of materials resistant to high temperatures, such as polyimide.

It is moreover possible to customize only the external interface or the internal layout of the power module that require changes based on customers' requests, without changing to molding tool (advantage in in terms of POA) or the leadframe. The plastic case topology needs not to be changed or adapted.

Finally, it is clear that modifications and variations may be made to what has been described and illustrated herein without thereby departing from the scope of the present invention, as defined in the attached claims.

In particular, the core of the present disclosure relates to a PCB 20 having: a first PCB region 32 having a stacked structure of piled up layers and/or films along the direction Z; a second PCB region 34 having said stacked structure, which further includes at a first side a top stiffening film 56 and at a second side, opposite to the first side along the direction Z, a bottom stiffening film 62; and a third PCB region 36 having said stacked structure without the top and bottom stiffening films 56, 62. The first PCB region 32 is in physical and electrical continuity with the second PCB region 34, and the second PCB region 34 is in physical and electrical continuity with the third PCB region 36. The top and bottom stiffening films 56, 62 are configured to locally increase the rigidity of the PCB 20 with respect to regions of the PCB 20 where said top and bottom stiffening films are absent. The PCB 20 can therefore be named rigid-flexible PCB, since it includes flexible portions 32, 36 and an intermediate rigid portion 34.

Moreover, the chamber 102 in figures 7A and 7B may not be closed on the left-hand side of the figures, i.e., the chamber 103 is open to the external environment.

Moreover, the stiffeners 106a, 106b may be shaped along the Z axis, that is they may have any shape (not necessarily rectangular shape as shown, but any polygonal or irregular shape) and any thickness (even variable thickness along the Z axis). The PCB portion between the stiffeners is flexible and therefore it may follow the shape of the stiffeners.

## Claims

1. A power module (10), comprising:
- a first portion (30, 12), comprising a substrate (12, 40-42) including conductive material;
- a second portion (32, 36), including a PCB (20) having a stacked structure of layers piled-up along a first direction (Z), electrically coupled to the rigid substrate (12) at a coupling region;
- a molding case (14), embedding part of the rigid substrate (12) and part of the PCB (20) and having a surface (14c) from which the PCB (20) protrudes out of the molding case (14),
wherein, at said surface (14c) of the molding case (14), the stacked structure of the PCB (20) is locally delimited at a first side by a top stiffening element (56) and at a second side, opposite to the first side along the first direction (Z), by a bottom stiffening element (62),
the top and bottom stiffening elements being configured to locally increase the rigidity of the PCB (20) with respect to regions of the PCB (20) where said top and bottom stiffening elements are absent.

2. The power module of claim 1, wherein the top and bottom stiffening elements (56, 62) have an extension which is limited to a transition region (35) of the PCB (20) from the inside of the molding case (14) to the outside of the molding case (14).

3. The power module of claim 2, wherein the PCB (20) has an elongated shape having a main extension along a second direction (X) orthogonal to the first direction (Z).

4. The power module of claim 3, wherein the PCB (20) has an extension, along the second direction (X) higher than 2 mm, and said top and bottom stiffening elements (56, 62) have an extension, along the second direction (X), higher than 2 mm.

5. The power module of anyone of the preceding claims, wherein both the top stiffening element (56) and the bottom stiffening element (62) are at least in part embedded within the molding case (14).

6. The power module of anyone of the preceding claims, wherein the top and the bottom stiffening elements (56, 62) are in direct physical contact with the molding case (14).

7. The power module of anyone of the preceding claims, wherein the PCB (20) has first and second PCB regions (20a, 20b) having a first rigidity value and a third PCB region (35) having a second rigidity value higher than the first rigidity value.

8. The power module of anyone of claim 7,
wherein each of the first and second PCB regions (20a, 20b) comprises said stacked structure, and
wherein the third PCB region comprises: said stacked structure, the top stiffening element (56) on a first side of the stacked structure and the bottom stiffening element (62) on a second side, opposite to the first side along the first direction (Z), of the stacked structure.

9. The power module of anyone of claim 7 or claim 8, wherein, the first PCB region (20a) is embedded within the molding case (14) and the second PCB region (20b) protrudes out of the molding case (14) and is configured to be freely moved and/or bended.

10. The power module of anyone of claims 7-9, the first rigidity value being such that the second PCB region (20b) can be bended up to 90 degrees or 180 degrees or up to 360 degrees with respect to a rest condition of the PCB (20), without losing its functionalities.

11. The power module of anyone of the preceding claims, wherein the top stiffening element (56) and the bottom stiffening element (62) are films of polyimide material with a respective thickness, along the first direction (Z), in the range 30-1500 µm.

12. The power module of anyone of the preceding claims, wherein the top stiffening element (56) and the bottom stiffening element (62) are of at least one material from among: Kapton^{®}, FR4, IMS, polyimide, plastic material, aluminum, stainless steel, copper, an alloy of aluminum, stainless steel, copper.

13. The power module of anyone of the preceding claims, wherein the top stiffening element (56) and the bottom stiffening element (62) are of Kapton at least one material from among: Kapton^{®}, FR4, IMS, polyimide, plastic material, aluminum, stainless steel, copper, an alloy of aluminum, stainless steel, copper.

14. The power module of anyone of the preceding claims, wherein the PCB (20) includes a connector configured to be electrically connected to a further printed circuit board.

15. The power module of anyone of the preceding claims, wherein the stacked structure of the PCB includes at least a first conductive layer (44) sandwiched between two insulating layers (47, 58).

16. The power module of claim 15, wherein the stacked structure of the PCB further includes at least a second conductive layer (48) and an intermediate insulating layer (46) between the first and the second conductive layer (44, 48),
the first conductive layer (44), the second conductive layer (48) and the intermediate insulating layer (46) being sandwiched between said two insulating layers (47, 58).

17. The power module of anyone of the preceding claims, wherein the top and bottom stiffening elements (56, 62) are coupled to said stacked structure of the PCB by means of respective adhesive films (54, 64).

18. A method of manufacturing a power module (10), the power module including:
a substrate (12) including conductive material;
a PCB (20) having: a first PCB region having a stacked structure of piled up layers and/or films along a first direction (Z); a second PCB region having said stacked structure locally delimited at a first side by a top stiffening element (56) and at a second side, opposite to the first side along the first direction (Z), by a bottom stiffening element (62); and a third PCB region consisting of said stacked structure, wherein the first PCB region is electrically coupled between the rigid substrate (12) and a first end of the second PCB region, and the third PCB region is electrically coupled to a second end, opposite to the first end, of the second PCB region, and wherein the top and bottom stiffening elements are configured to locally increase the rigidity of the PCB (20) with respect to said first and third regions of the PCB (20) where said top and bottom stiffening elements are absent,
the method including the steps of:
- providing a mold (100) having a base element (100b) and a cap element (100a), one among the base element and the cap element being provided with a passing hole (108), the base element and the cap element being shaped such as to define a first inner chamber (101), a second inner chamber (102) and a restriction region (104, 106a, 106b), including a first protrusion (106a) from the base element and a second protrusion (106b) from the cap element, between the first inner chamber and the second inner chamber;
- arranging the power module (10) on a supporting portion within said base element, in such a way that the top stiffening element (56) is in correspondence of the first protrusion (106a) and the bottom stiffening element (62) is in correspondence of the second protrusion (106b);
- coupling together the base element and the cap element, applying a pressure (P) on the top and bottom stiffening elements through the first and second protrusions (106a, 106b);
- injecting a resin (16) within the first inner chamber (101) though the passing hole (108);
- solidifying the resin (16) within the first inner chamber (101); and
- removing the mold (100).

19. A PCB (20), comprising:
- a first PCB region (20a, 32);
- a second PCB region (20b, 36);
- a third PCB region (34);
wherein the first, second and third PCB regions extend with physical and electrical continuity with one another,
said stacked structure including a plurality of piled-up layers along a first direction (Z),
wherein each of the first and second PCB regions (20a, 20b) comprises said stacked structure, and
wherein the third PCB region comprises: said stacked structure, a top stiffening element (56) on a first side of the stacked structure, and a bottom stiffening element (62) on a second side, opposite to the first side along the first direction (Z), of the stacked structure,
the top and bottom stiffening elements being configured to locally increase a rigidity of the PCB (20) at the third PCB region.

20. The PCB (20) of claim 19, wherein the first (20a, 32) and the second (20b, 36) PCB region are of a flexible type.

21. The PCB (20) of claim 19, wherein the first (20a, 32) and the second (20b, 36) PCB region are configured to be bended up to at least 90 degrees or up to at least 180 degrees or up to 360 degrees with respect to a rest condition of the PCB (20), without losing its functionalities.
